# EUROPEAN PATENT APPLICATION

(11) **EP 4 603 906 A1**
(43) Date of publication of application: **20.08.2025**
(21) Application number: 23917866.8
(22) Date of filing: 09.11.2023
(51) Int. Cl.: G02F 1/13357, G02F 1/1333

(54) **DISPLAY APPARATUS**

(30) Priority: 17.01.2023 KR 20230006907
(71) Applicant: Samsung Electronics Co., Ltd., Suwon-si, Gyeonggi-do 16677 (KR)
(72) Inventor: LEE, Kyungmin, Suwon-si Gyeonggi-do 16677 (KR); HWANG, Yongyeon, Suwon-si Gyeonggi-do 16677 (KR); KIM, Gyunghun, Suwon-si Gyeonggi-do 16677 (KR); PARK, Chulsoon, Suwon-si Gyeonggi-do 16677 (KR); PARK, Hyeonyeon, Suwon-si Gyeonggi-do 16677 (KR); JUNG, Jiseok, Suwon-si Gyeonggi-do 16677 (KR)
(74) Representative: Appleyard Lees IP LLP
(86) International application number: PCT/KR2023/017940
(87) International publication number: WO 2024/154912

(57) **Abstract**

A display apparatus comprises: a rear chassis having curvature; a plurality of LED plates including a flexible material to be fastened to the front of the rear chassis in a shape corresponding to the rear chassis, and having a plurality of LEDs mounted thereon; and a diffuser plate provided on the front of the plurality of LED plates to diffuse light incident from the plurality of LEDs. The display apparatus comprises a support member supporting the rear of the plurality of LED plates at the front of the rear chassis, wherein the support member supports the edges of the plurality of LED plates at the boundary between the plurality of LED plates.

## Description

### [Technical Field]

The disclosure relates to a display apparatus improved to reduce the variation in the optical distance between a light emitting diode (LED) plate, on which a plurality of LEDs are mounted thereon, and a diffuser plate disposed arranged on a front side of the LED plate.

### [Background Art]

Generally, a display apparatus is a kind of an output apparatus that converts obtained or stored electrical information into visual information and displays the visual information to a user, and the display apparatus is used in various fields, such as home or workplace.

The display apparatus includes a monitor apparatus connected to a personal computer or a server computer, a portable computer device, a navigation terminal device, a general television apparatus, an Internet Protocol television (IPTV), a portable terminal device, such as a smart phone, a tablet PC, a personal digital assistant (PDA) or a cellular phone, various display apparatuses used to reproduce images, such as advertisements or movies in an industrial field, or various kinds of audio/video systems.

The display apparatus includes a light source module to convert electrical information into visual information, and the light source module includes a plurality of light sources configured to independently emit light. Each of the plurality of light sources includes a light-emitting diode (LED) or an organic light-emitting diode (OLED). For example, the LED or the OLED may be mounted on a plate such as a circuit board or a substrate.

A plate on which light emitting diodes (LEDs) or organic light emitting diodes (OLEDs) are mounted may be provided at a front side thereof with a diffuser plate for diffusing light incident from the LEDs or OLEDs.

### [Disclosure]

### [Technical Problem]

One aspect of the disclosure provides a display apparatus capable of supporting edges of a plurality of LED plates fastened to a front side of a rear chassis from the front side of the rear chassis to prevent the edges of the plurality of LED plates from sagging in a direction toward the rear chassis.

One aspect of the disclosure provides a display apparatus capable of supporting edges of a plurality of LED plates fastened to a front side of a rear chassis from the front of the rear chassis to prevent central portions of the plurality of LED plates from being lifted from the rear chassis.

One aspect of the disclosure provides a display apparatus capable of supporting edges of a plurality of LED plates fastened to a front side of a rear chassis from the front side of the rear chassis to reduce the variation in the optical distance between the plurality of LED plates and the diffuser plate.

One aspect of the disclosure provides a display apparatus capable of supporting edges of a plurality of LED plates fastened to a front side of a rear chassis from the front side of the rear chassis to prevent mura from occurring on a display panel.

One aspect of the disclosure provides a display apparatus in which a beading is formed on a front side of a rear chassis to support, from the front of the rear chassis, edges of a plurality of LED plates fastened to the front side of the rear chassis.

One aspect of the disclosure provides a display apparatus in which a support member is attached to a front side of a rear chassis to support, from the front side of the rear chassis, edges of a plurality of LED plates fastened to the front side of the rear chassis.

One aspect of the disclosure provides a display apparatus in which a support member is provided only at positions corresponding to boundaries between a plurality of LED plates, thereby reducing material costs.

The technical objectives of the disclosure are not limited to the above, and other objectives that are not described above will be clearly understood by those skilled in the art from the above detailed description.

### [Technical Solution]

A display apparatus according to an embodiment of the disclosure includes: a rear chassis having a curvature; a plurality of light emitting diodes (LED) plates including a flexible material to be fastened to a front side of the rear chassis in a shape corresponding to the rear chassis, and having a plurality of LEDs mounted thereon; and a diffuser plate provided on a front side of the plurality of LED plates and configured to diffuse light incident from the plurality of LEDs. The display apparatus includes a support member provided on the front side of the rear chassis and configured to support a rear side of the plurality of LED plates, the support member being configured to support edges of the plurality of LED plates at boundaries between the plurality of LED plates.

A display apparatus according to an embodiment of the disclosure includes: a rear chassis having a curvature; a plurality of light emitting diodes (LED) plates including a flexible material to be fastened to a front side of the rear chassis in a shape corresponding to the rear chassis, and having a plurality of LEDs mounted thereon; and a diffuser plate provided on a front side of the plurality of LED plates and configured to diffuse light incident from the plurality of LEDs. The display apparatus includes a beading provided on the front side of the rear chassis and protruding toward the plurality of LED plates to support edges of the plurality of LED plates at boundaries between the plurality of LED plates.

### [Description of Drawings]

FIG. 1 is a drawing illustrating a display apparatus according to an embodiment.
FIG. 2 is a drawing illustrating a process in which a plurality of LED plates are fastened to a front side of a rear chassis of a display apparatus according to an embodiment.
FIG. 3 is a drawing illustrating a state in which a plurality of LED plates are fastened to a front side of a rear chassis of a display apparatus according to an embodiment.
FIG. 4 is a drawing illustrating a state in which a diffuser plate is assembled to a front side of a plurality of LED plates of the display apparatus shown in FIG. 3.
FIG. 5 is a drawing illustrating a view in which a plurality of beadings are formed on the front of a rear chassis of a display apparatus according to an embodiment.
FIG. 6 is a drawing schematically illustrating a state in which a plurality of LED plates are fastened to a front side of a rear chassis and a diffuser plate is provided on a front side of the plurality of LED plates according to an embodiment.
FIG. 7 is a drawing schematically illustrating a view in which a beading formed on a front side of a rear chassis supports a rear side of a plurality of LED plates according to an embodiment.
FIG. 8 is a drawing illustrating a state in which beadings are formed to protrude from a front side of a rear chassis with one beading protruding at each boundary between a plurality of LED plates according to an embodiment.
FIG. 9 is a drawing illustrating a process in which support members are attached to a front side of a rear chassis, the support member being provided in plural and attached at each boundary between a plurality of LED plates according to an embodiment.
FIG. 10 is a drawing illustrating a process in which support members are attached to a front side of a rear chassis, the support member being provided in a single unit and attached at each boundary between a plurality of LED plates according to an embodiment.

### [Modes of the Invention]

Embodiments described in the specification and configurations shown in the accompanying drawings are merely examples of the disclosure, and various modifications may replace the embodiments and the drawings of the disclosure at the time of filing of the application.

Further, identical symbols or numbers in the drawings of the disclosure denote components or elements configured to perform substantially identical functions.

Further, terms used herein are only for the purpose of describing particular embodiments and are not intended to limit to the disclosure. The singular form is intended to include the plural form as well, unless the context clearly indicates otherwise. It should be further understood that the terms "include," "including," "have," and/or "having" specify the presence of stated features, integers, steps, operations, elements, components, and/or groups thereof, but do not preclude the presence or addition of one or more other features, integers, steps, operations, elements, components, and/or groups thereof.

Further, it should be understood that, although the terms "first," "second," etc. may be used herein to describe various elements, the elements are not restricted by the terms, and the terms are only used to distinguish one element from another. For example, a first element could be termed a second element, and similarly, a second element could be termed a first element without departing from the scope of the disclosure. The term "and/or" includes combinations of one or all of a plurality of associated listed items.

The terms "front", "rear", "left", "right", and the like as herein used are defined with respect to the drawings, but the terms may not restrict the shape and position of the respective components.

Hereinafter, embodiments according to the disclosure will be described in detail with reference to the accompanying drawings.

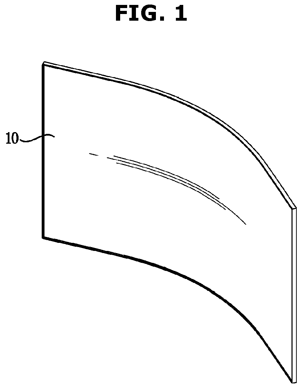

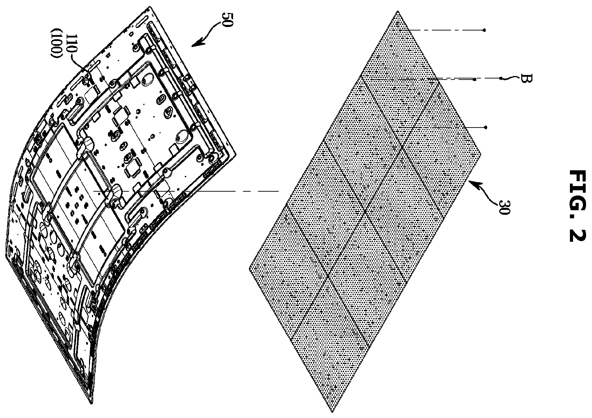

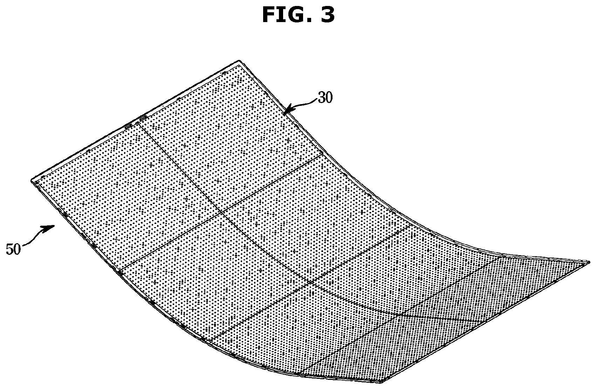

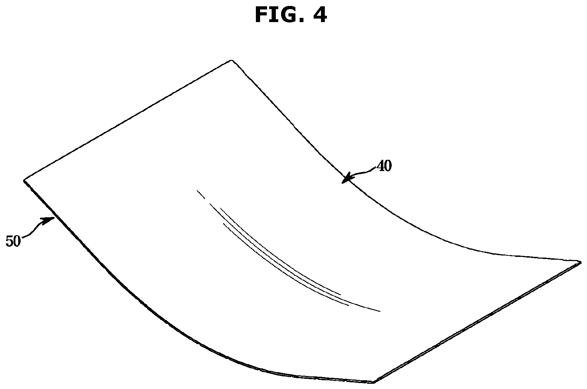

FIG. 1 is a drawing illustrating a display apparatus according to an embodiment. FIG. 2 is a drawing illustrating a process in which a plurality of LED plates are fastened to a front side of a rear chassis of a display apparatus according to an embodiment. FIG. 3 is a drawing illustrating a state in which a plurality of LED plates are fastened to a front side of a rear chassis of a display apparatus according to an embodiment. FIG. 4 is a drawing illustrating a state in which a diffuser plate is assembled to a front side of a plurality of LED plates of the display apparatus shown in FIG. 3.

Referring to FIGS. 1 to 4, a display apparatus may be a curved display apparatus. The display apparatus may include a display module that displays image information and a stand (not shown) that rotatably supports the display module.

The display module may include a display panel 10 that displays an image, a backlight unit 20 disposed on a rear side of the display panel 10 and provided to emit light to the display panel 10, and a rear chassis 50 disposed on the rear side of the backlight unit 20, which is the rear side of the display panel 10.

The rear chassis 50 may form the rear appearance of the display apparatus. The rear chassis 50 may be formed to have a curvature. The rear chassis 50 may be formed to be curved in a streamlined shape to have a curvature. That is, the display apparatus may be a curved display apparatus.

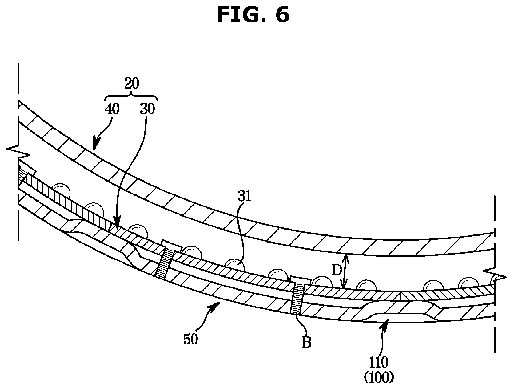

The backlight unit 20 may include a plurality of light emitting diode (LED) plates 30 that are fastened to a front side of the rear chassis 50. The backlight unit 20 may include a diffuser plate 40 provided on a front side of the plurality of LED plates 30. The diffuser plate 40 may be provided on the front side of the plurality of LED plates 30 to diffuse light incident from the plurality of LED plates 30 (see FIG. 6).

Each of the plurality of LED plates 30 may have a plurality of LEDs 31, see FIG. 6), which serve as light sources, mounted thereon. The plurality of LED plates 30 may be formed in a flat panel shape. The plurality of LED plates 30 may be formed of a flexible material to be deformed into a shape corresponding to that of the rear chassis 50, to which the plurality of LED plates 30 are fastened. That is, since the plurality of LED plates 30 are formed of a flexible material, the plurality of LED plates 30 may be deformed into a shape corresponding to the rear chassis 50 having a curvature and fastened to the front side of the rear chassis 50.

The plurality of LED plates 30 may be fastened to the front side of the rear chassis 50 by the plurality of fastening members B. Although the plurality of LED plates 30 are illustrated as eight LED plates in the drawing, the disclosure is not limited thereto. For example, the plurality of LED plates 30 may be formed as four LED plates. Alternatively, the plurality of LED plates 30 may be formed as twelve or more LED plates.

Each of the plurality of LED plates 30 may be fastened to the front side of the rear chassis 50 by four fastening members B. Although the drawing shows that each of the plurality of LED plates 30 is fastened to the rear chassis 50 by four fastening members B, the disclosure is not limited thereto. The four fastening members B may be fastened to portions adjacent to edges of each of the plurality of LED plates 30. The four fastening members B may be fastened to portions adjacent to corners of each of the plurality of LED plates 30. The four fastening members B may be fastened to portions located about 20 mm to 80 mm from the edges of each of the plurality of LED plates 30.

Since each of the plurality of LED plates 30 is fastened to the front side of the rear chassis 50 by the four fastening members B at positions adjacent to the edges of each of the plurality of LED plates 30, edge portions of each of the plurality of LED plates 30 may come into close contact with the rear chassis 50 compared to central portions of each of the plurality of LED plates 30. That is, the central portions of each of the plurality of LED plates 30 may be lifted from the rear chassis 50 compared to the edge portions. As a result, an optical distance (D, see FIG. 6) between the plurality of LED plates 30 and the diffuser plate 40 provided on the front side of the plurality of LED plates 30 may not be constant. In other words, there may be a variation in the optical distance D between the plurality of LED plates 30 and the diffuser plate 40. In other words, each of the plurality of LED plates 30 may come into close contact with the rear chassis 50 in areas adjacent to the four fastening members B, and may be lifted off from the rear chassis 50 in areas farther from the four fastening members B.

When the positions of the four fastening members B are adjacent to the edge portions of each of the plurality of LED plates 30, the edge portions of each of the plurality of LED plates 30 may come into close contact with to the rear chassis 50, but the central portions of each of the plurality of LED plates 30 may be spaced apart from the rear chassis 50. On the contrary, when the position of the four fasteners B are distant from the edge portion of each of the plurality of LED plates 30, the central portion of each of the plurality of LED plates 30 may become adjacent to the rear chassis 50, but the edge portion of each of the plurality of LED plates 30 may be spaced apart from the rear chassis 50.

When the optical distance D between the plurality of LED plates 30 and the diffuser plate 50 is not constant and a variation occurs, a dark spot or a blur may locally occur on the screen of the display panel 10. In a portion in which the optical distance D between the plurality of LED plates 30 and the diffuser plate 50 is relatively greater, a dark spot may occur on the screen of the display panel 10 compared to other portions. In a portion in which the optical distance D between the plurality of LED plates 30 and the diffuser plate 50 is relatively smaller, bright spots may occur on the screen of the display panel 10 compared to other portions. That is, Mura may occur on the screen of the display panel 10. To prevent Mura from occurring on the screen of the display panel 10, variation in optical distance between the plurality of LED plates 30 and the diffuser plate 40 may be reduced. To reduce the variation in optical distance between the plurality of LED plates 30 and the diffuser plate 40, support members 100 configured to support the rear sides of the plurality of LED plates 30 may be provided on the front side of the rear chassis 50.

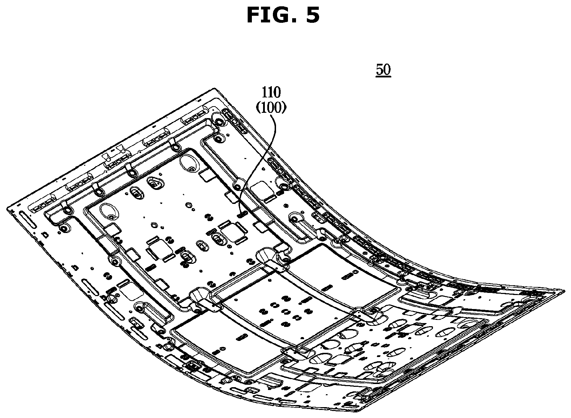

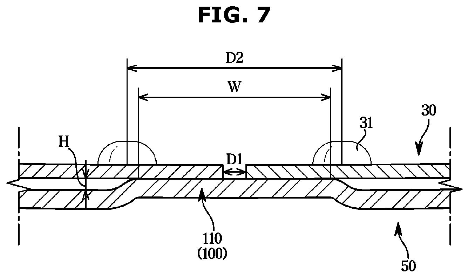

FIG. 5 is a drawing illustrating a view in which a plurality of beadings are formed on the front of a rear chassis of a display apparatus according to an embodiment. FIG. 6 is a drawing schematically illustrating a state in which a plurality of LED plates are fastened to a front side of a rear chassis and a diffuser plate is provided on a front side of the plurality of LED plates according to an embodiment. FIG. 7 is a drawing schematically illustrating a view in which a beading formed on a front side of a rear chassis supports a rear side of a plurality of LED plates according to an embodiment.

Referring to FIGS. 5 to 7, a support member 100 may be provided on the front side of the rear chassis 50. A plurality of the support members 100 may be provided on the front side of the rear chassis 50 to support the rear surfaces of the plurality of LED plates 30. The support members 100 may support edges of the plurality of LED plates 30 at the boundaries between the plurality of LED plates 30. The support members 100 may support the edges of the plurality of LED plates 30 and push the edges of the plurality of LED plates 30 in a direction toward the diffuser plate 40. When the support members 100 push the edges of the plurality of LED plates 30 in the direction toward the diffuser plate 40, the central portions of the plurality of LED plates 30 may be prevented from being lifted off from the rear chassis 50. That is, when the central portions of the plurality of LED plates 30 are prevented from being lifted off from the rear chassis 50 by the support members 100, the variation in the optical distance D between the plurality of LED plates 30 and the diffuser plate 40 may be reduced.

The support member 100 may be provided as a beading 110 protruding from the front side of the rear chassis 50 toward the plurality of LED plates 30. The beading 110 may be provided in plural. The beadings 110 may be arranged along a longitudinal boundary among the boundaries between the plurality of LED plates 30. The beadings 110 may be formed at a position corresponding to a longitudinal boundary among the boundaries between the plurality of LED plates 30. Here, the longitudinal direction may be a direction based on the display apparatus shown in FIG. 1. That is, as shown in FIG. 2, when a plurality of LED plates 30 are provided as eight LED plates, the beadings 110 may be formed in three rows, which are longitudinal boundaries among the boundaries between the plurality of LED plates 30. The beadings 110 formed in each of the three rows may be formed in plural.

An interval D1 between the plurality of LED plates 30 may be about 0.9 mm to 1.1 mm. A width W of the beading 110 formed on the rear chassis 50 may be about 5mm to 10 mm. A height H of the beading 110 may be about 0.3mm to 0.5 mm. Here, the width W of the beading 110 may be the length in the lateral direction based on the display apparatus shown in FIG. 1. The height H of the beading 110 may be the height at which the beading 110 protrudes from the front side of the rear chassis 50. The width W of the beading 110 formed on the rear chassis 50 may be a length smaller than an interval D2 between the centers of the plurality of LEDs 31 mounted on the plurality of LED plates 30. That is, the width W of the beading 110 formed on the rear chassis 50 may be longer than the interval D1 between the plurality of LED plates 30 and smaller than the interval D2 between the centers of the plurality of LEDs 31. Accordingly, the plurality of beadings 110 disposed at the boundaries between the plurality of LED plates 30 may be provided to support edges of two LED plates 30. The beadings 110 may be provided in plural at a boundary between every two LED plates 30. That is, the plurality of beadings 110 disposed at the boundary between the plurality of LED plates 30 may be provided to push edges of two LED plates 30 toward the diffuser plate 40.

When the edges of the plurality of LED plates 30 are supported by the plurality of beadings 110, the central portions of the plurality of LED plates 30 may be prevented from being lifted, thereby allowing the optical distance D between the plurality of LED plates 30 and the diffuser plate 40 to become approximately constant. That is, the variation in the optical distance D between the plurality of LED plates 30 and the diffuser plate 40 is reduced, which may prevent mura from occurring on the display panel 10, see FIG. 1.

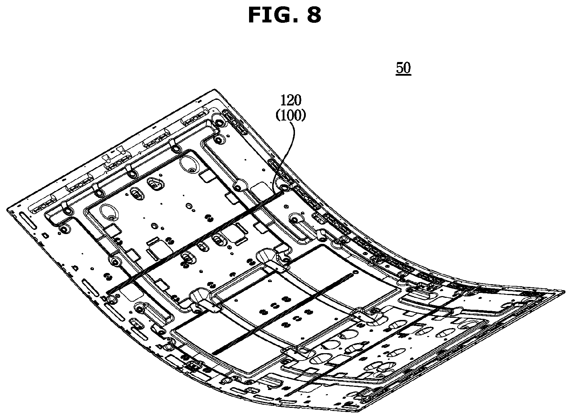

FIG. 8 is a drawing illustrating a state in which beadings are formed to protrude from a front side of a rear chassis with one beading protruding at each boundary between a plurality of LED plates according to an embodiment.

As shown in FIG. 8, the beading 120 may be formed in plural. Although the beading 120 is formed in plural, only one beading 120 may be formed at each boundary between the plurality of LED plates 30. The beading 120 may be formed in a straight bar shape along a longitudinal boundary among the boundaries between the plurality of LED plates 30. In other words, the beading 120 may be formed in only one unit, not a plurality of units, along a longitudinal boundary among the boundaries between the plurality of LED plates 30. When a single beading 120 is formed along a longitudinal boundary among the boundaries between the plurality of LED plates 30, the beading 120 may support the edges of the plurality of LED plates 30 as a whole, thereby more effectively preventing mura occurring on the display panel 10, see FIG. 1.

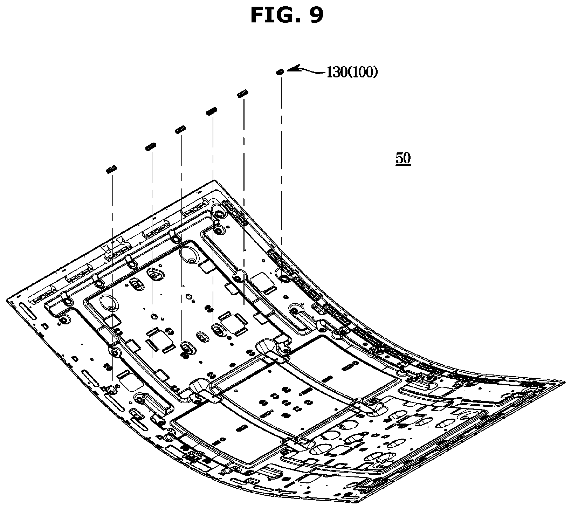

FIG. 9 is a drawing illustrating a process in which support members are attached to a front side of a rear chassis, the support member being provided in plural and attached at each boundary between a plurality of LED plates according to an embodiment.

As shown in FIG. 9, the supporting member 130 may be formed in plural and attached to the front side of the rear chassis 50. The supporting member 130 may be the same as the beading 110 shown in FIGS. 5 and 6, except that the supporting member 130 is provided separately and attached to the front side of the rear chassis 50. That is, the supporting member 130 may be attached to the front side of the rear chassis 50 at a position corresponding to the boundary between plurality of LED plates 30. The supporting member 130 may be attached to the front side of the rear chassis 50 at a position corresponding to the longitudinal boundary among the boundaries between plurality of LED plates 30. The support member 130 may be provided in plural at each position corresponding to the longitudinal boundary among boundaries between the plurality of LED plates 30.

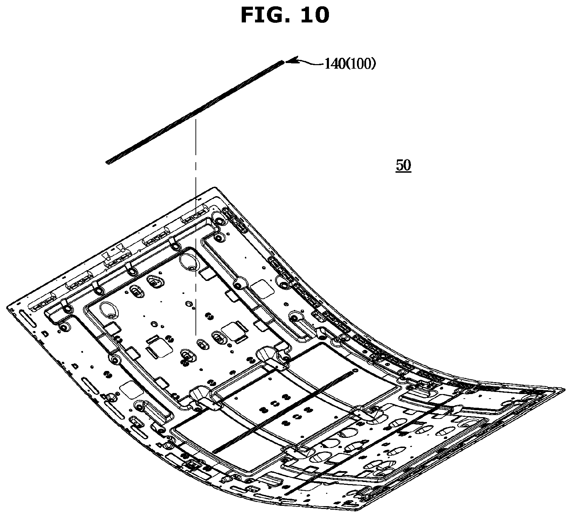

FIG. 10 is a drawing illustrating a process in which support members are attached to a front side of a rear chassis, the support member being provided in a single unit and attached at each boundary between a plurality of LED plates according to an embodiment.

As shown in FIG. 10, the support member 140 may be formed in plural and attached to the front side of the rear chassis 50. The support member 140 may be the same as the beading 120 shown in FIG. 8, except that the support member 140 is provided separately and attached to the front side of the rear chassis 50. That is, the support member 140 may be attached to the front side of the rear chassis 50 at a position corresponding to the boundary between the plurality of LED plates 30. The support member 140 may be attached to the front side of the rear chassis 50 at a position corresponding to a longitudinal boundary among the boundaries between the plurality of LED plates 30. The support member 140 may be provided in a single unit at each position corresponding to a longitudinal boundary among boundaries between the plurality of LED plates 30. The support member 140 may be provided in a straight bar shape along a longitudinal boundary among boundaries between the plurality of LED plates 30.

A display apparatus according to an embodiment of the disclosure includes: a rear chassis 50 having a curvature; a plurality of light emitting diodes (LED) plates 30 including a flexible material to be fastened to a front side of the rear chassis in a shape corresponding to the rear chassis, and having a plurality of LEDs 31 mounted thereon; and a diffuser plate 40 provided on a front side of the plurality of LED plates and configured to diffuse light incident from the plurality of LEDs. The display apparatus includes a support member 100 provided on the front side of the rear chassis and configured to support a rear side of the plurality of LED plates, the support member being configured to support edges of the plurality of LED plates at boundaries between the plurality of LED plates. According to the disclosure, the support member 100 supports the edges of the plurality of LED plates 30 fastened to the front side of the rear chassis 50 from the front side of the rear chassis to prevent the edges of the plurality of LED plates from sagging in a direction toward the rear chassis. The support member 100 supports the edges of the plurality of LED plates 30 fastened to the front side of the rear chassis 50 from the front side of the rear chassis to prevent central portions of the plurality of LED plates from being lifted from the rear chassis. The support member 100 supports the edges of the plurality of LED plates 30 fastened to the front side of the rear chassis 50 from the front side of the rear chassis to reduce the variation in the optical distance between the plurality of LED plates and the diffuser plate. The support member 100 supports the edges of the plurality of LED plates 30 fastened to the front side of the rear chassis 50 from the front side of the rear chassis to prevent mura from occurring on a display panel 10. The support member 100 is provided only at positions corresponding to boundaries between a plurality of LED plates 30, thereby reducing material costs.

The support member may be configured to push the edges of the plurality of LED plates in a direction toward the diffuser plate at the boundaries between the plurality of LED plates to reduce a variation in an optical distance D between the plurality of LED plates and the diffuser plate.

The support member may be configured to push the edges of the plurality of LED plates to prevent central portions of the plurality of LED plates from being lifted from the rear chassis.

The support member may be formed as a beading 110 or 120 that protrudes from the front side of the rear chassis toward the plurality of LED plates.

The beading 110 may be provided as a plurality of beadings, and the plurality of beading may be arranged along a longitudinal boundary among the boundaries between the plurality of LED plates. According to the disclosure, the beading 110 is disposed only along the longitudinal boundary among the boundaries between the plurality of LED plates 30, thereby reducing material costs.

The beading 120 may be provided in a straight bar shape along a longitudinal boundary among the boundaries between the plurality of LED plates. According to the disclosure, an area of the beading 120 supporting the edges of the plurality of LED plates 30 is increased, thereby more efficiently preventing mura from occurring on the display panel 10.

An interval between the plurality of LED plates may be about 0.9 mm to 1.1 mm, and a width of the beading may be approximately 5 mm to 10 mm.

The width of the beading may be smaller than an interval D2 between centers of the plurality of LEDs.

A height H of the beading may be approximately 0.3 mm to 0.5 mm.

The support member 130 or 140 may be attached to the front side of the rear chassis and configured to support the edges of the plurality of LED plates.

The support member 130 may be provided as a plurality of support members, and the plurality of support members may be attached to a position corresponding to a longitudinal boundary among the boundaries between the plurality of LED plates. According to the disclosure, the support member 130 is provided only at a position corresponding to a longitudinal boundary among the boundaries between the plurality of LED plates, thereby reducing the material cost.

The support member 140 may be provided as a straight bar shape and attached at a position corresponding to a longitudinal boundary among the boundaries between the plurality of LED plates. According to the disclosure, an area of the support member 140 supporting the edges of the plurality of LED plates 30 is increased, thereby more efficiently preventing mura from occurring on the display panel 10.

The support member may be provided at a boundary between every two LED plates among the boundaries between the plurality of LED plates.

The support member may be configured to push edges of every two LED plates in a direction toward the diffuser plate.

The support member may be provided as a plurality of support members at a boundary between every two LED plates, and provided at a position corresponding to a longitudinal boundary among the boundaries between every two LED plates. According to the disclosure, the support member 100 is disposed only along the longitudinal boundary among the boundaries between every two LED plates, thereby reducing material costs.

A display apparatus according to an embodiment of the disclosure includes: a rear chassis 50 having a curvature; a plurality of light emitting diodes (LED) plates 30 including a flexible material to be fastened to a front side of the rear chassis in a shape corresponding to the rear chassis, and having a plurality of LEDs 31 mounted thereon; and a diffuser plate 40 provided on a front side of the plurality of LED plates and configured to diffuse light incident from the plurality of LEDs. The display apparatus includes a beading 110 or 120 provided on the front side of the rear chassis and protruding toward the plurality of LED plates to support edges of the plurality of LED plates at boundaries between the plurality of LED plates. According to the disclosure, the support member 100 supports the edges of the plurality of LED plates 30 fastened to the front side of the rear chassis 50 from the front side of the rear chassis to prevent the edges of the plurality of LED plates from sagging in a direction toward the rear chassis. The support member 100 supports the edges of the plurality of LED plates 30 fastened to the front side of the rear chassis 50 from the front side of the rear chassis to prevent central portions of the plurality of LED plates from being lifted from the rear chassis. The support member 100 supports the edges of the plurality of LED plates 30 fastened to the front side of the rear chassis 50 from the front side of the rear chassis to reduce the variation in the optical distance between the plurality of LED plates and the diffuser plate. The support member 100 supports the edges of the plurality of LED plates 30 fastened to the front side of the rear chassis 50 from the front side of the rear chassis to prevent mura from occurring on a display panel 10. The support member 100 is provided only at positions corresponding to boundaries between a plurality of LED plates 30, thereby reducing material costs.

The beading 110 may be arranged along a longitudinal boundary among the boundaries between the plurality of LED plates and may be provided as a plurality of beadings at each of the boundaries between the plurality of LED plates. The beading 110 may be disposed only along the longitudinal boundary among the boundaries between the plurality of LED plates 30, thereby reducing material costs.

The beading may push the edges of the plurality of LED plates toward the diffuser plate at the boundaries between the plurality of LED plates, thereby preventing the edges of the plurality of LED plates from sagging toward the rear chassis
The beading may push the edges of the plurality of LED plates, thereby preventing the center portions of the plurality of LED plates from being lifted off from the rear chassis.

A width W of the beading in the traverse direction may be larger than an interval D1 between the plurality of LED plates and smaller than an interval D2 between the centers of the plurality of LEDs.

The effects of the present invention are not limited to those described above, and other effects that are not described above will be clearly understood by those skilled in the art from the above detailed description.

While the display apparatus has been described above with reference to the accompanying drawings, focusing on specific shapes and orientations, it will be understood by those skilled in the art that various modifications and alterations can be made thereto. Such modifications and alterations should be construed as falling within the scope of the disclosed invention.

## Claims

1. A display apparatus comprising:
a rear chassis having a curvature;
a plurality of light emitting diodes (LED) plates including a flexible material to be fastened to a front side of the rear chassis in a shape corresponding to the rear chassis, and having a plurality of LEDs mounted thereon;
a diffuser plate provided on a front side of the plurality of LED plates and configured to diffuse light incident from the plurality of LEDs; and
a support member provided on the front side of the rear chassis and configured to support a rear side of the plurality of LED plates, the support member being configured to support edges of the plurality of LED plates at boundaries between the plurality of LED plates.

2. The display apparatus of claim 1, wherein the support member is configured to push the edges of the plurality of LED plates in a direction toward the diffuser plate at the boundaries between the plurality of LED plates to reduce a variation in an optical distance between the plurality of LED plates and the diffuser plate.

3. The display apparatus of claim 2, wherein the support member is configured to push the edges of the plurality of LED plates to prevent central portions of the plurality of LED plates from being lifted from the rear chassis.

4. The display apparatus of claim 1, wherein the support member is formed as a beading that protrudes from the front side of the rear chassis toward the plurality of LED plates.

5. The display apparatus of claim 4, wherein the beading is provided as a plurality of beadings, and the plurality of beading are arranged along a longitudinal boundary among the boundaries between the plurality of LED plates.

6. The display apparatus of claim 4, wherein the beading is provided in a straight bar shape along a longitudinal boundary among the boundaries between the plurality of LED plates.

7. The display apparatus of claim 4, wherein an interval between the plurality of LED plates is about 0.9 mm to 1.1 mm, and a width of the beading is approximately 5 mm to 10 mm.

8. The display apparatus of claim 7, wherein the width of the beading is smaller than an interval between centers of the plurality of LEDs.

9. The display apparatus of claim 4, wherein a height of the beading is approximately 0.3 mm to 0.5 mm.

10. The display apparatus of claim 1, wherein the support member is attached to the front side of the rear chassis and configured to support the edges of the plurality of LED plates.

11. The display apparatus of claim 10, wherein the support member is provided as a plurality of support members, and the plurality of support members are attached to a position corresponding to a longitudinal boundary among the boundaries between the plurality of LED plates.

12. The display apparatus of claim 10, wherein the support member is provided as a straight bar shape and attached at a position corresponding to a longitudinal boundary among the boundaries between the plurality of LED plates.

13. The display apparatus of claim 1, wherein the support member is provided at a boundary between every two LED plates among the boundaries between the plurality of LED plates.

14. The display apparatus of claim 13, wherein the support member is configured to push edges of every two LED plates in a direction toward the diffuser plate.

15. The display apparatus of claim 14, wherein the support member is provided as a plurality of support members at a boundary between every two LED plates, and provided at a position corresponding to a longitudinal boundary among the boundaries between every two LED plates.
